# EUROPÄISCHE PATENTSCHRIFT

(11) **EP 2 327 095 B1**
(45) Veröffentlichungstag und Bekanntmachung des Hinweises auf die Patenterteilung: **19.09.2012**
(21) Anmeldenummer: 09780513.9
(22) Anmeldetag: 13.07.2009
(51) Int. Cl.: H01L 23/15, H01L 23/492

(54) **HALBLEITERANORDNUNG SOWIE VERFAHREN ZUM HERSTELLEN EINER HALBLEITERANORDNUNG**
SEMICONDUCTOR ARRANGEMENT AND METHOD FOR PRODUCING A SEMICONDUCTOR ARRANGEMENT
ENSEMBLE SEMI-CONDUCTEUR ET PROCÉDÉ DE FABRICATION D'UN ENSEMBLE SEMI-CONDUCTEUR

(30) Priorität: 12.09.2008 DE 102008042035
(43) Veröffentlichungstag der Anmeldung: 01.06.2011
(73) Patentinhaber: Robert Bosch GmbH, 70442 Stuttgart (DE)
(72) Erfinder: KRAUSS, Andreas, 72072 Tuebingen (DE)
(86) Internationale Anmeldenummer: PCT/EP2009/058924
(87) Internationale Veröffentlichungsnummer: WO 2010/028880

(56) Entgegenhaltungen:
- EP-A- 0 217 176
- EP-A- 0 468 382
- WO-A-2008/041813
- DE-A1- 10 247 409
- DE-A1- 19 846 638

## Beschreibung

### Stand der Technik

Die Erfindung betrifft eine Halbleiteranordnung gemäß dem Oberbegriff des Anspruchs 1, eine Verwendung gemäß Anspruch 12 sowie ein Verfahren zum Herstellen einer Halbleiteranordnung gemäß Anspruch 13.

Für die Verkapselung (Packaging) thermisch hochbelasteter Halbleiterbauteile werden zur Zeit keramische Gehäuse oder Substrate verwendet, bei denen die Keramik als Träger für das Halbleiterbauteil dient und gleichzeitig als elektrische Isolierung wirkt. Das Halbleiterbauteil wird in der Regel von seiner Unterseite entweder mit leitfähigem, oder isolierendem Kleber auf dem Keramikträger befestigt oder aufgelötet. Eine derartige Halbleiteranordnung ist in der DE 10 2005 038 760 A1 beschrieben. Bei der aus dieser Druckschrift bekannten Halbleiteranordnung ist das Halbleiterbauteil über eine vergleichsweise dicke Metallschicht an dem Keramikträger festgelegt. Da die vergleichsweise dicke Metallschicht einen von dem Halbleitermaterial des Halbleiterbauteils und der Trägerkeramik unterschiedlichen Wärmeausdehnungskoeffizienten aufweist, kann es insbesondere bei hoher Temperaturbeanspruchung der Halbleiteranordnung zu die Halbleiteranordnung zerstörenden mechanischen Spannungen kommen.

Bei alternativen, bekannten Halbleiteranordnungen werden für Halbleiterbauteile Gehäuse aus Metall verwendet, auf denen die Halbleiterbauteile mit ihrer Unterseite elektrisch leitfähig befestigt werden, wobei isolierte Verbindungen, z.B. über Glas-Durchführungen realisiert werden.

Dokument WO2008/041813 offenbart eine Halbleiteranordnung mit einem Träger aus elektrisch leitender Keramik.

Als Standard für die Verkapselung von Leistungshalbleiterbauteilen, wie Transistoren, haben sich Gehäuse durchgesetzt, bei denen das Halbleiterbauteil auf einem gestanzten Metallträger, einem so genannten Lead-Frame, leitfähig aufgeklebt wird, wobei zusätzliche elektrische Verbindungen über weitere gestanzte Kontakte realisiert werden und das Halbleiterbauteil und die Kontakte mit einem isolierenden Material, in der Regel Kunststoff oder ein kunststoffbasierter Werkstoff, umspritzt werden.

Sämtliche bekannten Konzepte stoßen bezüglich der maximal zulässigen Temperaturen, insbesondere bei Einsatz von so genannten Wide-Bandgap-Halbleiterbauteilen, an ihre Grenzen. Dies ist insbesondere bei Temperaturen von über 250°C, insbesondere bei gleichzeitiger Einwirkung weiterer wittriger Bedingungen, wie Vibrationen oder bei dem Einsatz in einer korrosiven Umgebung der Fall.

### Offenbarung der Erfindung

### Technische Aufgabe

Der Erfindung liegt die Aufgabe zugrunde, ein Halbleiteranordnungskonzept vorzuschlagen, das den Einsatz der Halbleiteranordnung bei hohen Temperaturen ermöglicht. Insbesondere sollen mechanische Spannungen aufgrund großer Temperaturunterschiede vermieden werden. Ferner besteht die Aufga-be darin, ein Verfahren zum Herstellen einer derartigen Halbleiteranordnung vorzuschlagen.

### Technische Lösung

Diese Aufgabe wird hinsichtlich der Halbleiteranordnung mit den Merkmalen des Anspruchs 1, mit einer Verwendung gemäß Anspruch 13 sowie hinsichtlich des Verfahrens mit den Merkmalen des Anspruchs 14 gelöst. Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen. Zur Vermeidung von Wiederholungen sollen verfahrensgemäß offenbarte Merkmale als vorrichtungsgemäß offenbart gelten und beanspruchbar sein. Ebenso sollen vorrichtungsgemäß offenbarte Merkmale als verfahrensgemäß offenbart gelten und beanspruchbar sein.

Der Erfindung liegt der Gedanke zugrunde, den Träger für das Halbleiterbauteil, zumindest abschnittsweise, aus einer, zumindest unter Einsatztemperaturbedingungen, elektrisch leitenden, insbesondere metallisch leitenden, Keramik auszubilden, wodurch es möglich wird, die Spannungs- und/oder Stromversorgung des Halbleiterbauteils unmittelbar über den keramischen Träger zu realisieren, insbesondere ohne, dass es dabei notwendig ist, die im Stand der Technik erforderlichen, vergleichsweise dicken Metallschichten mit einer Dickenerstreckung von mehr als 30µm einzusetzen. Der Verzicht auf derartig dicke metallische Zwischenschichten zwischen dem Halbleiterteil und dem keramischen Träger führt wiederum dazu, dass mechanische Spannungen aufgrund unterschiedlicher Wärmeausdehnungskoeffizienten vermieden werden, wodurch sich die nach dem Konzept der Erfindung ausgebildeten Halbleiteranordnung für den Einsatz bei sehr hohen Temperaturen, insbesondere bei Temperaturen von (weit) über 250°C, vorzugsweise von über 400°C, eignet. Zudem zeichnet sich ein zumindest abschnittsweise aus elektrisch leitendem Keramikmaterial ausgebildeter Träger durch eine sehr hohe thermische Leitfähigkeit aus, die für eine gute Wärmeabfuhr sorgt und damit den Einsatz bei sehr hohen Temperaturen weiter begünstigt. Grundsätzlich kann das mindestens eine Halbleiterbauteil in beliebiger Weise, beispielsweise als Diode, Transistor oder integrierte Schaltung (IC), etc. ausgebildet werden. Besonders bevorzugt ist eine Ausführungsform, bei der es sich bei dem Halbleiterbauteil um einen so genannten Rohchip (Die) handelt, der beispielsweise durch Löten oder andere Verfahren auf dem zumindest abschnittsweise elektrisch leitenden keramischen Träger festgelegt ist. Bevorzugt ist eine Ausführungsform der Halbleiteranordnung, bei der elektrisch leitende keramische Träger mindestens eine erste Kontaktierung, insbesondere eine Massekontaktierung des Halbleiterbauteils bildet, wobei hierzu die Verbindungstechnik bzw. das Verbindungsmaterial zur Anbindung des Halbleiterbauteils auf dem elektrisch leitenden keramischen Träger bevorzugt ebenfalls elektrisch leitend sein sollte und bevorzugt nur so dick sein sollte, dass kritische mechanische Spannungen aufgrund unterschiedlicher Temperaturkoeffizienten vermieden werden. So ist es beispielsweise möglich das Halbleiterbauteil durch Silbersintern an dem keramischen Träger festzulegen, wobei die Sinterschicht beispielsweise durch eine Rückseitenmetallisierung mit einer sehr geringen Dickenerstreckung unmittelbar beim Herstellungsprozess des Halbleiterbauteils auf dieses aufgebracht werden kann.

Ganz besonders bevorzugt eignet sich eine nach dem Konzept der Erfindung ausgebildete Halbleiteranordnung für den Einsatz in einem Kraftfahrzeug. So ist es beispielsweise möglich eine derartige Halbleiteranordnung, umfassend beispielsweise mindestens eine SiC-Leistungsdiode, im oder an einem Generator einer KFZ-Lichtmaschine einzusetzen, wobei die SiC-Leistungsdioden direkt, beispielsweise über eine Dünnschicht, auf die SiC-Keramikelemente aufgebracht sind, die mit ihren ausgezeichneten mechanischen Eigenschaften, wie Verschleiß- und Temperaturbeständigkeit auch weitere Funktionen mit entsprechenden, später noch zu erläuternden, fakultativen, Funktionsstrukturabschnitten übernehmen können.

In Weiterbildung der Erfindung ist mit Vorteil vorgesehen, dass das Halbleiterbauteil ein so gennantes Wide-Bandgap-Halbleitermaterial umfasst bzw. aus einem derartigen ausgebildet ist. Bei Wide-Bandgap-Halbleitermaterial handelt es sich um Halbleitermaterialien mit einer großen Bandlücke von vorzugsweise größer als 2eV. Das Wide-Bandgap-Halbleitermaterial, wie beispielsweise SiC, zeichnet sich durch die Möglichkeit aus, bei wesentlich höheren Temperaturen als Silizium betrieben werden zu können.

Ganz besonders bevorzugt ist eine Ausführungsform der Halbleiteranordnung, bei der der elektrisch leitende keramische Träger und das Halbleiterbauteil zumindest näherungsweise den gleichen Wärmeausdehnungskoeffizienten aufweisen, um das Auftreten von temperaturbedingten mechanischen Spannungen, vorzugsweise vollständig, zu vermeiden. Auf einfache Weise kann die Realisierung eines gleichen Wärmeausdehnungskoeffizienten realisiert werden, wenn der elektrisch leitende keramische Träger und das Halbleiterbauteil aus dem gleichen Grundmaterial, vorzugsweise aus Wide-Bandgap-Halbleitermaterial, ausgebildet sind. Dabei ist es möglich, den keramischen Träger nur abschnittsweise aus dem gleichen Material auszubilden, wobei es im Falle der nur abschnittsweise gleichen Materialwahl bevorzugt ist, das Halbleiterbauteil und den keramischen Träger im Befestigungsbereich aus dem gleichen Material auszubilden.

Besonders bevorzugt ist der elektrisch leitende keramische Träger, bei dem es sich auch um einen Zwischenträger handeln kann, Bestandteil eines das Halbleiterbauteil verkapselnden Gehäuses oder der keramische Träger bildet das Gehäuse für das Halbleiterbauteil vollständig selbst.

Der keramische Träger weist mindestens einen elektrisch leitenden und mindestens einen elektrisch nicht leitenden Bereich auf, wobei es weiter bevorzugt ist, den elektrisch leitenden Bereich des keramischen Trägers mit dem Halbleiterbauteil zu kontaktieren. Die Realisierung mindestes eines elektrisch leitenden und mindestens eines elektrisch nicht leitenden Bereichs kann durch eine entsprechende Materialwahl, also das Vorsehen von unterschiedlichen keramischen Materialien in den unterschiedlichen Bereichen des keramischen Trägers, realisiert werden. Im einfachsten Fall ist der keramische Träger als Plättchen bzw. Scheibe ausgebildet.
Bei geeigneter Gestaltung von elektrisch leitenden und elektrisch nicht leitenden Bereichen des Keramikträgers können bereits über den Keramikträger mehrere elektrische Verbindungen hergestellt werden. Gegebenenfalls können weitere Verbindungen direkt von Kontakten auf dem Halbleiterbauteil, beispielsweise über metallische Anschlussleitungen, hergestellt werden, die zum direkten Anschluss des Halbleiterbauteils dienen und/oder die auf elektrisch isolierende oder elektrisch leitende Bereiche des Keramikträgers führen. Gegebenenfalls kann der beim Anschluss dieser Leitungen, beispielsweise durch einen Schweißvorgang, entstehende Druck und/oder die entstehende Wärme für das Ausbilden, beispielsweise Fügen, Härten, Löten, etc. der Verbindung zwischen dem Halbleiterbauteil und dem keramischen Träger genutzt werden.

Im Hinblick auf die Ausbildung des elektrisch leitenden keramischen Trägers bzw. im Hinblick auf die Anordnung der elektrisch leitenden und elektrisch nicht leitenden (isolierenden) Bereiche des keramischen Trägers gibt es unterschiedliche Möglichkeiten. So können in einer einfachsten Ausführungsform elektrisch leitende und elektrisch nicht leitende Bereiche in einer Ebene, also vorzugsweise mit einer vergleichsweise geringen Dickenerstreckung, nebeneinander angeordnet werden. Bei einer alternativen Ausführungsform können elektrisch leitende und elektrisch nicht leitende Bereiche als dreidimensionale Struktur zusammengefasst werden, die eine komplexere Leitungs- bzw. Isolationsführung bzw. -anordnung ermöglicht.

Wie eingangs erwähnt, ermöglicht eine nach dem Konzept der Erfindung ausgebildete Haltleiteranordnung den Verzicht auf dicke Haftvermittler- bzw. Zwischenschichten zwischen dem Halbleiterbauteil und dem keramischen Träger. So ist es nun beispielsweise möglich das Halbleiterbauteil über mindestens eine als Dünnschicht ausgebildete Hilfsschicht (insbesondere Haftvermittlerschicht) an dem keramischen Träger festzulegen, wobei unter einer Dünnschicht eine Schicht mit einer Dickenerstreckung von weniger als 5µm, besonders bevorzugt von weniger als 2µm, ganz besonders bevorzugt von weniger als 1µm, verstanden wird. Diese Dünnschicht kann beispielsweise durch Aufdampfen mindestens einer dünnen Metallschicht, insbesondere Titanschicht, realisiert werden, um das Halbleiterbauteil und/oder den Keramikträger für das Kleben oder Löten vorzubereiten. Ganz besonders bevorzugt wird die Dünnschicht als Rückseitenmetallisierung des Halbleiterbauteils bereits während der Herstellung des Halbleiterbauteils realisiert. Dabei ist es ganz besonders bevorzugt, wenn es sich bei der Dünnschicht um eine sinterfähige Schicht handelt.

Generell ist festzustellen, dass, falls das Fügen des Halbleiterbauteils und des keramischen Trägers durch Löten erfolgt, dies bei einer Temperatur durchgeführt werden sollte, die unterhalb der Einsatztemperatur des Halbleiterbauteils liegt. Beispielsweise kann zum Fügen Hartlot in einem Temperaturbereich zwischen 600°C und 900°C eingesetzt werden. Alternativ ist eine Verbindung auch über eutektisches Bonden oder einen Klebevorgang, oder einen Aufglasungs- bzw. Aufschmelzungsvorgang realisierbar, vorzugsweise bei vergleichsweise geringen Temperaturen.

In Weiterbildung der Erfindung ist mit Vorteil vorgesehen, dass der keramische Träger neben der Trage- bzw. Haltefunktion für das Halbleiterbauteil mindestens eine weitere Funktion übernimmt. Hierzu weist der keramische Träger bevorzugt einen mechanischen Funktionsstrukturabschnitt auf, beispielsweise in der Form eines Befestigungsabschnittes und/oder eines Kühlkörperabschnittes und/oder eines Lagerabschnittes, beispielsweise zur Bildung eines Gleitlagers, etc. Der mechanische Funktionsstrukturabschnitt kann dabei entweder aus elektrisch leitfähiger oder elektrisch nicht leitfähiger Keramik ausgebildet werden, wobei es besonders bevorzugt ist, den Funktionsstrukturabschnitt faserverstärkt auszuführen. Auch ist es möglich, den keramischen Träger als Verbundbauteil mit mindestens einem nicht keramischen, vorzugsweise den Funktionsstrukturabschnitt bildenden, Material auszubilden, um auch sehr komplexe Strukturformen sicher und bruchgeschützt realisieren zu können.

Im Hinblick auf die konkrete Ausbildung des Funktionsstrukturabschnittes gibt es unterschiedliche Möglichkeiten. So kann dieser beispielsweise mindestens eine Öffnung, beispielsweise zur Aufnahme eines Befestigungselementes, wie einer Schraube, etc. umfassen. Auch ist es möglich den Funktionsstrukturabschnitt mit mindestens einer Ausrichtnase und/oder mindestes einer Rastnase auszubilden. Zusätzlich oder alternativ kann der Funktionsstrukturabschnitt einen stiftförmigen Abschnitt, insbesondere zum Festlegen des keramischen Trägers an einem weiteren Bauteil, aufweisen.

Die Erfindung führt auch auf die Verwendung einer an sich bekannten, zumindest abschnittsweise, elektrisch leitenden Keramik, insbesondere einer so genannten Wide-Bandgap-Keramik, als Träger für ein Halbleiterbauteil, mit den zuvor beschriebenen überraschenden Vorteilen.

Darüber hinaus führt die Erfindung auf ein Verfahren zum Herstellen einer Halbleiteranordnung, die ganz besonders bevorzugt wie zuvor beschrieben ausgebildet ist. Kern des Verfahrens ist das Bereitstellen eines zumindest abschnittsweise elektrisch leitenden keramischen Trägers, der bei Bedarf auch als Verbundbauteil, umfassend einen nichtkeramischen Abschnitt ausgebildet sein kann. Bevorzugt erfolgt das Fügen des Halbleiterbauteils und des keramischen Trägers derart, dass das Halbleiterbauteil mindestens einen elektrisch leitenden Abschnitt des keramischen Trägers kontaktiert, so dass der keramische Träger mindestens eine elektrische Anbindung des Halbleiterbauteils realisiert.

Bevorzugt wird das Halbleiterbaumaterial unter Realisierung einer als Dünnschicht ausgebildeten Hilfsschicht an dem keramischen Träger festgelegt, wobei eine Dünnschicht mit einer Dickenerstreckung von weniger als 5µm am Halbleiterbauteil und/oder am keramischen Material, beispielsweise durch Aufdampfen, vorgesehen werden kann.

Ganz besonders bevorzugt ist das Auftragen der Hilfsschicht durch Rückseitenbeschichten, insbesondere Rückseitenmetallisierung des Halbleiterbauteils, vorzugsweise bei dessen Herstellungsprozess.

### Kurze Beschreibung der Zeichnungen

Weitere Vorteile, Merkmale und Einzelheiten der Erfindung ergeben sich aus der nachfolgenden Beschreibung eines bevorzugten Ausführungsbeispiels sowie anhand der Zeichnungen. Diese zeigen in:
- Fig. 1:: ein Beispiel (nicht Teil der Erfindung) einer Halbleiteranordnung, bei der der keramische Träger vollständig aus elektrisch leitender Keramik ausgebildet ist,
- Fig. 2:: eine Halbleiteranordnung, umfassend einen keramischen Träger, der zwei elektrisch leitfähige und einen elektrisch isolierenden Bereich aufweist und
- Fig. 3:: eine Halbleiteranordnung mit einem keramischen Träger, der dreidimensional angeordnete elektrisch leitende und elektrisch nicht leitende Bereiche umfasst.

### Ausführungsformen der Erfindung

In den Figuren sind gleiche Elemente und Elemente mit der gleichen Funktion mit den gleichen Bezugszeichen gekennzeichnet.

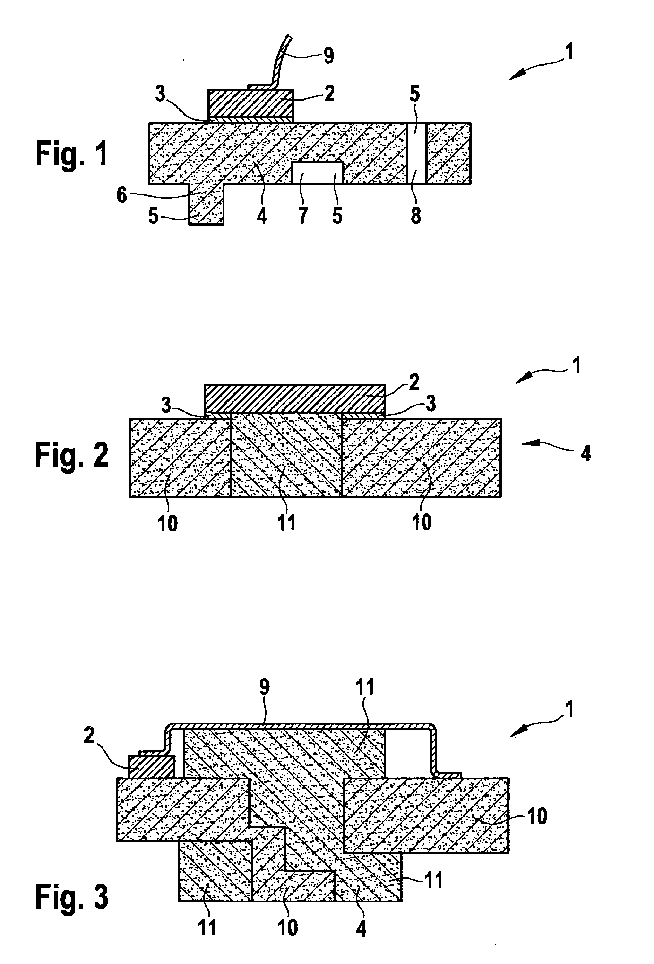

Fig. 1 zeigt eine Halbleiteranordnung 1 mit einem als Rohchip ausgebildeten Halbleiterbauelement 2, welches über eine als Klebeschicht ausgebildete Hilfsschicht 3 (Dünnschicht) an einem keramischen Träger 4 festgelegt ist. Die Hilfsschicht 3 ist elektrisch leitend, um einen Massekontakt über den keramischen Träger 4 zu dem Halbleiterbauteil 2 herzustellen. Der keramische Träger 4 ist in dem gezeigten Beispiel vollständig aus elektrisch leitendem keramischen Material ausgebildet, wobei zusätzlich zu dem elektrisch leitfähigen keramischen Material, bei alternativen Ausführungsformen nicht elektrisch leitfähiges keramisches Material sowie nicht keramisches Material, beispielsweise zur Ausbildung der im Folgenden noch zu erläuternden Funktionsstrukturabschnitte, aufweisen kann.

Wie erwähnt, umfasst der elektrisch leitfähige, keramische Träger 4 insgesamt drei Funktionsstrukturabschnitte 5, die in dem gezeigten Beispiel unmittelbar in dem elektrisch leitfähigen Keramikmaterial ausgebildet sind. Ein erster, in der Zeichnungsebene linker Funktionsstrukturabschnitt 5 ist als Zentriernase 6, ein zweiter, in der Zeichnungsebene mittlerer Funktionsstrukturabschnitt 5 als Aussparung 7 und ein dritter, in der Zeichnungsebene rechter Funktionsstrukturabschnitt 5 als Durchgangsöffnung 8 ausgebildet.

Wie sich weiter aus Fig. 1 ergibt, ist das Halbleiterbauteil 2 nicht nur über den keramischen Träger 4, sondern über einen weiteren, hier als Drahtbondkontakt ausgeführten, zusätzlich elektrischen Kontakt 9 kontaktiert, der an der in der Zeichnungsebene oberen Seite des Halbleiterbauteils 2 festgelegt ist.

In dem gezeigten Beispiel gemäß Fig. 1 sind das Halbleiterbauteil 2 und der keramische Träger 4 aus dem gleichen Wide-Bandgap-Halbleiterkeramikmaterial, hier SiC, ausgebildet.

Das Ausführungsbeispiel gemäß Fig. 2 unterscheidet sich von dem zuvor beschriebenen Beispiel gemäß Fig. 1 im Wesentlichen dadurch, dass der keramische Träger 4 aus unterschiedlichen keramischen Materialen ausgebildet ist und zwei (äußere) elektrisch leitende Bereiche 10 und einen sandwichartig dazwischen aufgenommenen elektrisch nicht leitenden Bereich 11 (Isolator) aufweist. Die elektrisch leitenden und nicht leitenden Bereiche 10, 11 sind in einer im Wesentlichen zweidimensionalen Ebene nebeneinander angeordnet. Bemerkenswert ist, dass das Halbleiterbauteil 2 derart angeordnet ist, dass es mit zwei voneinander beabstandeten Kontaktbereichen beide elektrisch leitenden Bereiche 10 des Trägers 4 kontaktiert. Hierzu ist das Halbleiterbauteil 2 über jeweils eine als Sinterschicht ausgebildete Hilfsschicht 3 (Dünnschicht) mit den elektrisch leitenden Bereichen 10 verbunden.

Das Ausführungsbeispiel gemäß Fig. 3 zeigt eine weitere alternative Ausführungsform einer Halbleiteranordnung 1, umfassend ein Halbleiterbauteil 2 sowie einen komplex aufgebauten keramischen Träger 4, bei dem elektrisch leitende und elektrisch nicht leitende Bereiche 10, 11 in einer dreidimensionalen Strukturanordnung realisiert sind, wobei das Halbleiterbauteil 2 unmittelbar über eine zwischen zwei Dünnschichten realisierte, ebenfalls als Dünnschicht ausgebildete Lötschicht (nicht gezeigt) elektrisch leitend mit dem elektrisch leitenden Bereich 10 des keramischen Trägers 4 verbunden ist, wobei über einen weiteren, als Drahtverbindung ausgebildeten elektrischen Kontakt 9 eine elektrisch leitende Verbindung zwischen der Oberseite des Halbleiterbauteils 2 und einem weiteren elektrisch leitenden Bereich 10 des keramischen Trägers 4 hergestellt ist, wobei der weitere elektrisch leitende Bereich 10 durch einen elektrisch nicht leitenden Bereich 11 von dem das Halbleiterbauteil 2 tragenden, in der Zeichnungsebene linken elektrisch leitenden Bereich 10 isoliert ist.

## Patentansprüche

1. Halbleiteranordnung, umfassend mindestens ein Halbleiterbauteil (2), das fest auf einem keramischen Träger (4) angeordnet ist,
**dadurch gekennzeichnet,**
**dass** der keramische Träger (4) mindestens einen elektrisch leitenden und mindestens einen elektrisch nicht leitenden Bereich (10, 11) aus unterschiedlichen Keramischen Materialien

2. Halbleiteranordnung nach Anspruch 1,
**dadurch gekennzeichnet,**
**dass** das Halbleiterbauteil (2) Halbleitermaterial, insbesondere SiC, mit einer großen Bandlücke, vorzugsweise größer als 2 eV, umfasst.

3. Halbleiteranordnung nach einem der vorhergehenden Ansprüche,
**dadurch gekennzeichnet,**
**dass** der keramische Träger (4) und das Halbleiterbauteil (2) zumindest näherungsweise den gleichen Wärmeausdehnungskoeffizienten aufweisen.

4. Halbleiteranordnung nach einem der vorhergehenden Ansprüche,
**dadurch gekennzeichnet,**
**dass** der keramische Träger (4) und das Halbleiterbauteil (2) zumindest abschnittsweise aus dem gleichen Material ausgebildet sind.

5. Halbleiteranordnung nach einem der vorhergehenden Ansprüche,
**dadurch gekennzeichnet,**
**dass** der keramische Träger (4) ein das Halbleiterbauteil (2), zumindest abschnittsweise, vorzugsweise vollständig, umschließendes Gehäuse oder ein Gehäusebestandteil ist.

6. Halbleiteranordnung nach Anspruch 1,
**dadurch gekennzeichnet,**
**dass** der elektrisch nicht leitende Bereich (11) Träger von mindestens einer Leiterbahn ist.

7. Halbleiteranordnung nach einem der Ansprüche 1 oder 6,
**dadurch gekennzeichnet,**
**dass** die elektrisch leitenden und elektrisch nicht leitenden Bereiche (10, 11) in einer, vorzugsweise im wesentlichen zweidimensionalen, Ebene nebeneinander oder in einer dreidimensionalen Struktur angeordnet sind.

8. Halbleiteranordnung nach einem der vorhergehenden Ansprüche,
**dadurch gekennzeichnet,**
**dass** das Halbleiterbauteil (2) unter Beteiligung mindestens einer als Dünnschicht, vorzugsweise mit einer Dicke von weniger als 5µm, bevorzugt von weniger als 2µm, ganz besonders bevorzugt von weniger als 1µm, ausgebildete, bevorzugt metallische, Hilfsschicht (3), insbesondere durch Silbersintern, mit dem keramischen Träger (4) fest verbunden ist.

9. Halbleiteranordnung nach Anspruch 8,
**dadurch gekennzeichnet,**
**dass** die Hilfsschicht (3) eine durch Rückseitenbeschichten auf das Halbleiterbauteil (2) aufgebrachte Schicht ist.

10. Halbleiteranordnung nach einem der Ansprüche 1 bis 9,
**dadurch gekennzeichnet,**
**dass** der keramische Träger (4) einen mechanischen Funktionsstrukturabschnitt (5), insbesondere einen Befestigungsabschnitt, und/oder einen Kühlkörperabschnitt, und/oder einen Lagerabschnitt, aufweist.

11. Halbleiteranordnung nach Anspruch 10,
**dadurch gekennzeichnet,**
**dass** der Funktionsstrukturabschnitt (5) eine Öffnung zur Aufnahme eines Befestigungselementes, und/oder eine Ausrichtnase, und/oder eine Rastnase, und/oder einen Befestigungsstift umfasst.

12. Verwendung einer mindestens einen elektrisch leitenden und mindestens einen elektrisch nicht leitenden Bereich (10, 11) aus unterschiedlichen keramischen Materialien aufweisenden Keramik als Träger für ein Halbleiterbauteil (2).

13. Verfahren zum Herstellen einer Halbleiteranordnung (1) nach einem der Ansprüche 1 bis 11, umfassend folgende Schritte:
• Bereitstellen mindestens eines Halbleiterbauteils (2),
• Bereitstellen eines mindestens einen elektrisch leitenden und mindestens einen elektrisch nicht leitenden Bereich (10, 11) aus unterschiedlichen keramischen Materialien aufweisenden keramischen Trägers (4),
• Fügen des Halbleiterbauteils (2) mit dem keramischen Träger (4).

14. Verfahren nach Anspruch 13,
**dadurch gekennzeichnet,**
**dass** das Halbleiterbauteil (2) mit über mindestens eine als Dünnschicht ausgebildete Hilfsschicht (3), insbesondere einer Sinterschicht, mit dem keramischen Träger (4) verbunden wird.

15. Verfahren nach Anspruch 14,
**dadurch gekennzeichnet,**
**dass** die Hilfsschicht (3) durch Rückseitenbeschichten auf das Halbleiterbauteil (2) aufgebracht wird.

## Claims

1. Semiconductor arrangement, comprising at least one semiconductor component (2) arranged fixedly on a ceramic carrier (4),
**characterized**
**in that** the ceramic carrier (4) has at least one electrically conductive and at least one electrically non-conductive region (10, 11) composed of different ceramic materials.

2. Semiconductor arrangement according to Claim 1,
**characterized**
**in that** the semiconductor component (2) comprises semiconductor material, in particular SiC, having a large band gap, preferably of greater than 2 eV.

3. Semiconductor arrangement according to either of the preceding claims,
**characterized**
**in that** the ceramic carrier (4) and the semiconductor component (2) have at least approximately the same coefficient of thermal expansion.

4. Semiconductor arrangement according to any of the preceding claims,
**characterized**
**in that** the ceramic carrier (4) and the semiconductor component (2) are formed from the same material at least in sections.

5. Semiconductor arrangement according to any of the preceding claims,
**characterized**
**in that** the ceramic carrier (4) is a housing enclosing the semiconductor component (2), at least in sections, preferably completely, or a constituent part of the housing.

6. Semiconductor arrangement according to Claim 1,
**characterized**
**in that** the electrically non-conductive region (11) is a carrier of at least one conductor track.

7. Semiconductor arrangement according to either of Claims 1 and 6,
**characterized**
**in that** the electrically conductive and electrically non-conductive regions (10, 11) are arranged in a, preferably substantially two-dimensional, plane alongside one another or in a three-dimensional structure.

8. Semiconductor arrangement according to any of the preceding claims,
**characterized**
**in that** the semiconductor component (2) is fixedly connected to the ceramic carrier (4) with the participation of at least one, preferably metallic auxiliary layer (3) embodied as a thin layer, preferably having a thickness of less than 5 µm, preferably of less than 2 µm, especially preferably of less than 1 µm, in particular by silver sintering.

9. Semiconductor arrangement according to Claim 8,
**characterized**
**in that** the auxiliary layer (3) is a layer applied to the semiconductor component (2) by rear-side coating.

10. Semiconductor arrangement according to any of Claims 1 to 9,
**characterized**
**in that** the ceramic carrier (4) has a mechanical functional structure section (5), in particular a fixing section, and/or a heat sink section, and/or a bearing section.

11. Semiconductor arrangement according to Claim 10,
**characterized**
**in that** the functional structure section (5) comprises an opening for receiving a fixing element, and/or an aligning lug, and/or a latching lug, and/or a fixing pin.

12. Use of a ceramic having at least one electrically conductive and at least one electrically non-conductive region (10, 11) composed of different ceramic materials as a carrier for a semiconductor component (2).

13. Method for producing a semiconductor arrangement (1) according to any of Claims 1 to 11, comprising the following steps:
• providing at least one semiconductor component (2),
• providing a ceramic carrier (4) having at least one electrically conductive and at least one electrically non-conductive region (10, 11) composed of different ceramic materials,
• joining the semiconductor component (2) to the ceramic carrier (4).

14. Method according to Claim 13,
**characterized**
**in that** the semiconductor component (2) is concomitantly connected to the ceramic carrier (4) by means of at least one auxiliary layer (3) embodied as a thin layer, in particular a sintering layer.

15. Method according to Claim 14,
**characterized**
**in that** the auxiliary layer (3) is applied to the semiconductor component (2) by rear-side coating.

## Revendications

1. Ensemble semi-conducteur comprenant au moins un composant semi-conducteur (2) disposé fixement sur un support céramique (4),
**caractérisé en ce que**
le support céramique (4) présente au moins une partie électriquement conductrice et au moins une partie électriquement non conductrice (10, 11) constituées de matériaux céramiques différents.

2. Ensemble semi-conducteur selon la revendication 1, **caractérisé en ce que** le composant semi-conducteur (2) comporte un matériau semi-conducteur, en particulier le SiC, à grande largeur de bande, de préférence supérieure à 2 eV.

3. Ensemble semi-conducteur selon l'une des revendications précédentes, **caractérisé en ce que** le support céramique (4) et le composant semi-conducteur (2) présentent au moins approximativement les mêmes coefficients de dilatation thermique.

4. Ensemble semi-conducteur selon l'une des revendications précédentes, **caractérisé en ce qu'**au moins certaines parties du support céramique (4) et du composant semi-conducteur (2) sont formées d'un même matériau.

5. Ensemble semi-conducteur selon l'une des revendications précédentes, **caractérisé en ce que** le support céramique (4) est un boîtier ou un composant de boîtier qui entoure au moins des parties et de préférence la totalité du composant semi-conducteur (2) .

6. Ensemble semi-conducteur selon la revendication 1, **caractérisé en ce que** la partie (11) électriquement non conductrice est un support pour au moins une piste conductrice.

7. Ensemble semi-conducteur selon l'une des revendications 1 ou 6, **caractérisé en ce que** la partie électriquement conductrice et la partie électriquement non conductrice (10, 11) sont disposées l'une à côté de l'autre dans un plan, de préférence essentiellement en deux dimensions, ou dans une structure en trois dimensions.

8. Ensemble semi-conducteur selon l'une des revendications précédentes, **caractérisé en ce que** le composant semi-conducteur (2) est relié solidairement au support céramique (4) à l'aide d'au moins une couche auxiliaire (3) configurée en couche mince, de préférence d'une épaisseur inférieure à 5 µm, de préférence inférieure à 2 µm et de façon tout particulièrement préférable inférieure à 1 µm, de préférence métallique, en particulier par frittage d'argent.

9. Ensemble semi-conducteur selon la revendication 8, **caractérisé en ce que** la couche auxiliaire (3) est une couche appliquée sur le composant semi-conducteur (2) par revêtement sur le côté dorsal.

10. Ensemble semi-conducteur selon l'une des revendications 1 à 9, **caractérisé en ce que** le support céramique (4) présente une partie structurelle (5) à fonction mécanique, en particulier une partie de fixation et/ou une partie de corps de refroidissement et/ou une partie de montage.

11. Ensemble semi-conducteur selon la revendication 10, **caractérisé en ce que** la partie structurelle (5) fonctionnelle comporte une ouverture de reprise d'un élément de fixation et/ou un bec d'alignement et/ou un bec d'encliquetage et/ou une tige de fixation.

12. Utilisation d'une céramique qui présente au moins une couche électriquement conductrice et au moins une couche électriquement non conductrice (10, 11) en matériaux céramiques différents comme support pour un composant semi-conducteur (2).

13. Procédé de fabrication d'un ensemble semi-conducteur (1) selon l'une des revendications 1 à 11, le procédé comportant les étapes suivantes :
préparer au moins un composant semi-conducteur (2),
préparer un support céramique (4) qui présente au moins une partie électriquement conductrice et au moins une partie électriquement non conductrice (10, 11) constituées de matériaux céramiques différents et
relier le composant semi-conducteur (2) au support céramique (4).

14. Procédé selon la revendication 13, **caractérisé en ce que** le composant semi-conducteur (2) est relié au support céramique (4) par au moins une couche auxiliaire (3) configurée comme couche mince, en particulier une couche frittée.

15. Procédé selon la revendication 14, **caractérisé en ce que** la couche auxiliaire (3) est appliquée sur le composant semi-conducteur (2) par revêtement du côté dorsal.
